# EUROPEAN PATENT APPLICATION

(11) **EP 4 386 867 A1**
(43) Date of publication of application: **19.06.2024**
(21) Application number: 22874220.1
(22) Date of filing: 11.05.2022
(51) Int. Cl.: H01L 31/0288, H01L 31/18, H01L 31/0216, H01L 31/0224

(54) **METHOD FOR MANUFACTURING BACK-CONTACT CELL**

(30) Priority: 30.09.2021 CN 202111165394
(71) Applicant: Longi Solar Technology (Taizhou) Co., Ltd., Taizhou, Jiangsu 225300 (CN)
(72) Inventor: LI, Zhonglan, Taizhou, Jiangsu 225300 (CN); LU, Weiming, Taizhou, Jiangsu 225300 (CN); LI, Hua, Taizhou, Jiangsu 225300 (CN); JIN, Yupeng, Taizhou, Jiangsu 225300 (CN)
(74) Representative: Loo, Chi Ching
(86) International application number: PCT/CN2022/092268
(87) International publication number: WO 2023/050822

(57) **Abstract**

The present disclosure discloses a method for manufacturing a back contact solar cell, which relates to the field of photovoltaic technology, and is used to simplify the manufacturing process. The manufacturing method includes: providing a substrate; forming sequentially a first interface passivation layer and a first doped layer on the first surface of the substrate; forming a first mask layer on merely a surface of the first doped layer that is located within the first doped region; removing the first doped layer and the first interface passivation layer that are located within the second doped region and the third region; forming sequentially a second interface passivation layer and a second doped layer on the first mask layer, the second doped region and the third region at a same time, wherein a conductive type of the second doped layer are opposite to a conductive type of the first doped layer; forming a second mask layer on merely a surface of the second doped layer that is located within the second doped region; removing the second doped layer and the second interface passivation layer that are located on the first mask layer and the third region, and maintaining merely the second interface passivation layer and the second doped layer that are located within the second doped region; and forming a first electrode on the first doped layer, and forming a second electrode on the second doped layer.

## Description

### CROSS REFERENCE TO RELEVANT APPLICATIONS

The present disclosure claims the priority of the Chinese patent application filed on September 30th, 2021 before the Chinese Patent Office with the application number of 202111165394.2 and the title of "METHOD FOR MANUFACTURING BACK-CONTACT CELL", which is incorporated herein in its entirety by reference.

### TECHNICAL FIELD

The present disclosure relates to the technology field of photovoltaics and, more particularly, to a method for manufacturing a back contact solar cell.

### BACKGROUND

A back contact solar cell refers to a cell that an emitter and metal contact are located on the back of the cell, and there are not metal electrodes shielding the front. Comparing with the cell with the front being shielded, the back contact solar cell has higher short-circuit current and photoelectric conversion efficiency, and is currently one of the technical directions to achieve high-efficiency crystalline silicon cells.

The existing method for manufacturing the back contact solar cell is more complicated, and has tedious steps, therefore a method for manufacturing the solar cell that is simple and that high-efficiency is ensured is needed.

### SUMMARY

An object of the present disclosure is to provide a method for manufacturing a back contact solar cell, to simplify the manufacturing process of back contact solar cells.

In the first aspect, a method for manufacturing a back contact solar cell is provided by the present disclosure, wherein the method includes:
providing a substrate, wherein the substrate has a first surface and a second surface facing to each other, and on the first surface, there are a first doped region and a second doped region that are arranged in stagger, and a third region for separating the first doped region and the second doped region;
forming sequentially a first interface passivation layer and a first doped layer on the first surface of the substrate;
forming a first mask layer on merely a surface of the first doped layer that is located within the first doped region;
removing the first doped layer and the first interface passivation layer that are located within the second doped region and the third region;
forming sequentially a second interface passivation layer and a second doped layer on the first mask layer, the second doped region and the third region at a same time, wherein a conductive type of the second doped layer is opposite to a conductive type of the first doped layer;
forming a second mask layer on merely a surface of the second doped layer that is located within the second doped region;
removing the second doped layer and the second interface passivation layer that are located at the first mask layer and the third region, and maintaining merely the second interface passivation layer and the second doped layer that are located within the second doped region; and
forming a first electrode on the first doped layer, and forming a second electrode on the second doped layer.

In a case of using the technical solution stated above, in the process of patterning the first doped layer and the second doped layer, the mask layers may be formed merely within the required regions, and the unnecessary mask layers within the other regions are avoided from being formed, the step of removing an unnecessary region mask layer is omitted. Furthermore, the patterning of the second doped layer (i.e., the process of removing the second doped layer within the region outside the second mask layer) and the formation of the third region are completed in the same step, the steps are simplified. In addition, in the fabrication of the second doped layer and the patterning of the second doped layer, the first mask layer is always maintained on the first doped layer. Therefore, in the patterning of the second doped layer, because of the effect of protection on the first doped layer by the first mask layer, the damage on the first doped layer is reduced, the conductive performance of the first doped layer is ensured.

In some possible embodiments, the first mask layer is a first oxide mask layer; and/or the second mask layer is a second oxide mask layer. Both of the first mask layer and the second mask layer are an oxide mask layer. The oxide mask layers may be formed directly by oxidation on the first doped layer and the second doped layer. Furthermore, the oxide mask layers, as compared with mask layers fabricated in other modes, for example, printed masks, have a higher cleanliness, do not introduce other elements, and may not bring other contamination or impact to the first doped layer and the second doped layer. The oxide masks are easy to wash.

In some possible embodiments, the first oxide mask layer is formed by, in an oxygen-containing atmosphere environment, performing laser-irradiation oxidation to merely the surface of the first doped layer that is located within the first doped region; and/or the second oxide mask layer is formed by, in the oxygen-containing atmosphere environment, performing laser-irradiation oxidation to merely the surface of the second doped layer that is located within the second doped region. In such a configuration, by forming the oxide mask layers by laser irradiation directly on the first doped layer and the second doped layer, the oxide mask layers have a high formation precision. As compared with mask layers formed by external heating oxidation or PECVD, the laser irradiation has a lower heat, the damage on the first doped layer and the second doped layer is reduced.

In some possible embodiments, a gas in the oxygen-containing atmosphere environment is one or more of oxygen, ozone, air, CO₂ and N₂O. In such an oxygen-containing atmosphere environment, by laser irradiation, the first doped layer and the second doped layer can have an oxidation reaction with the gas, to form the oxide mask layers on the surface.

In some possible embodiments, the second doped layer and the second interface passivation layer that are located on the first mask layer and the third region are removed by using an alkali solution, and a suede structure is formed continuously at the third region of the first surface and the second surface at a same time by using the same alkali solution. In such a configuration, the multiple process steps of the patterning of the second doped layer, the patterning of the third region and the texturing of the second surface of the substrate can be completed at a same time, in the same step by using the same one alkali solution, the process steps are highly reduced. The suede structure of the third region increases the level of the light trapping of the back of the back contact solar cell, and the power generation capacity is increased. The process step of the texturing of the second surface is after the formation of the first doped layer and the second doped layer, the integrality of the suede structure of the second surface and its light-trapping performance are ensured.

In some possible embodiments, the second doped layer and the second interface passivation layer that are located on the first mask layer and the third region are removed by using an alkali solution of KOH, NaOH or tetramethyl ammonium hydroxide with a mass percentage of 1wt%-5wt% at 70°C-90°C, and the suede structure is formed continuously at the third region of the first surface and the second surface at a same time by using the same alkali solution.

In some possible embodiments, the step of forming the first electrode on the first doped layer, and forming the second electrode on the second doped layer specifically includes:
removing the first mask layer located on the first doped layer and the second mask layer located on the second doped layer;
forming a first surface passivation layer at the first doped layer, the second doped layer and the third region at a same time; and
forming the first electrode on the first surface passivation layer located at the first doped layer, and forming the second electrode on the first surface passivation layer located at the second doped layer, wherein the first electrode is electrically contacted with the first doped layer, and the second electrode is electrically contacted with the second doped layer.

In a case of using the technical solution stated above, after the patterning of the first doped layer and the second doped layer and the formation of the third region are completed, the first mask layer and the second mask layer may be removed, to improve the performance of electrically conducting contacting between the first doped layer and the first electrode and between the second doped layer and the second electrode. Furthermore, the first surface passivation layer can perform surface passivation to the back contact solar cell, to passivate the dangling bonds at the first doped layer, the second doped layer and the third region, to reduce the recombination rate of the carriers at the first surface, and increase the photoelectric conversion efficiency. The first electrode and the second electrode are electrically contacted with the first doped layer and the second doped layer via a first opening and a second opening respectively, to form local ohmic contacting between the metals and the semiconductors, the contact areas between the metal electrodes and the first doped layer and the second doped layer are reduced, the contact resistances are reduced, the recombination rates of the carriers at the surfaces of the electrodes are further reduced, and the open-circuit voltage is increased.

In some possible embodiments, the first mask layer and the second mask layer are removed by using an etching solution containing a fluorine element. The mask layers can be more easily removed, by using the etching solution containing the fluorine element, especially the oxide mask layers. And/or, the step of forming the first surface passivation layer at the first doped layer, the second doped layer and the third region at a same time further includes forming a second surface passivation layer on the second surface. In such a configuration, the formation of the second surface passivation layer and the formation of the first surface passivation layer are in the same step, the steps are simplified, and the second surface passivation layer has the effect of reducing the incident-light reflection and passivating.

In some possible embodiments, the first doped layer and the second doped layer are formed by an in-situ doping method or a non-in-situ doping method.

In some possible embodiments, before the step of forming the first electrode on the first doped layer, and forming the second electrode on the second doped layer, the method further includes: performing a heat-treatment process, wherein the heat-treatment process crystallizes at least a part of the first doped layer and/or the second doped layer. In such a configuration, the electrical conductivities of the first doped layer and/or the second doped layer are increased. The heat treatment enables the first interface passivation layer and the second interface passivation layer to be more beneficial to the selectivity and transmissibility of the carriers. The heating can cause the doped element to enter the first interface passivation layer, the second interface passivation layer and the substrate, thereby the transmission resistance is reduced.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the related art, the figures that are required to describe the embodiments or the related art will be briefly described below. Apparently, the figures that are described below are embodiments of the present disclosure, and a person skilled in the art can obtain other figures according to these figures without paying creative work.

The drawings illustrated herein are intended to provide a further understanding of the present disclosure, and form part of the present disclosure. The illustrative embodiments of the present disclosure and their explanation are intended to interpret the present disclosure, and do not inappropriately limit the present disclosure. In the drawings:
FIG. 1 is a schematic structural diagram of a back contact solar cell according to an embodiment of the present disclosure;
FIG. 2-FIG. 10 are schematic diagrams of the states of the stages of the process of manufacturing the back contact solar cell according to the embodiments of the present disclosure;
FIG. 11 is a schematic diagram of the principle of the laser irradiation used in the method for manufacturing the back contact solar cell according to an embodiment of the present disclosure; and
FIG. 12 is a schematic flow chart of a method for manufacturing a back contact solar cell according to an embodiment of the present disclosure.

### Reference numbers:

10-substrate, 101-first doped region,
102-second doped region, 103-third region,
11-first doped layer, 12-second doped layer,
13-first surface passivation layer, 131-first opening,
132-second opening, 14-first interface passivation layer,
15-second interface passivation layer, 16-first mask layer,
17-second mask layer, 18-second surface passivation layer,
20-first electrode, 21-second electrode,
30- container, 301-gas inlet, and
302-gas outlet

### DETAILED DESCRIPTION

In order to make the technical problem sought to solve, the technical solutions and the advantageous effects of the present disclosure clearer, the present disclosure will be described in further detail below with reference to the drawings and the embodiments. It should be understood that the particular embodiments described herein are merely intended to interpret the present disclosure, and are not intended to limit the present disclosure.

It should be noted that, if an element is described as "fixed to" or "provided at" another element, it may be directly at another element or indirectly at another element. If an element is described as "connected to" another element, it may be directly connected to another element or indirectly connected to another element.

Moreover, the terms "first" and "second" are merely for the purpose of describing, and should not be construed as indicating or implying the degrees of importance or implicitly indicating the quantity of the specified technical features. Accordingly, the features defined by "first" and "second" may explicitly or implicitly include one or more of the features. In the description of the present disclosure, the meaning of "plurality of" is "two or more", unless explicitly and particularly defined otherwise. The meaning of "several" is "one or more", unless explicitly and particularly defined otherwise.

In the description of the present disclosure, it should be understood that the terms that indicate orientation or position relations, such as "upper", "lower", "front", "rear", "left" and "right", are based on the orientation or position relations shown in the drawings, and are merely for conveniently describing the present disclosure and simplifying the description, rather than indicating or implying that the device or element must have the specific orientation and be constructed and operated according to the specific orientation. Therefore, they should not be construed as a limitation on the present disclosure.

In the description of the present disclosure, it should be noted that, unless explicitly defined or limited otherwise, the terms "mount", "connect" and "link" should be interpreted broadly. For example, it may be fixed connection, detachable connection, or integral connection; it may be mechanical connection or electrical connection; and it may be direct connection or indirect connection by an intermediate medium, and may be the internal communication between two elements or the interaction between two elements. A person skilled in the art can determine the particular meaning of the terms in the present disclosure according to particular situations.

As a new energy alternative solution, solar cells are more and more widely used at present. The solar cell is a device that converts the light energy of the sun into electrical energy. By using the photovoltaic principle, solar cells generate carriers, and then use the electrode to extract the carriers, which is conducive to the effective use of electrical energy.

Finger-shaped cross back contact solar cell is also known as IBC cell. IBC refers to the interdigitated back contact. The biggest feature of the IBC cell is that the emitter and the metal contact are on the back of the cell, and there are not effects of metal electrode shielding on the front, therefore the IBC cell has a higher short-circuit current Isc, and at the same time, a wider metal gate line can be allowed on the back to reduce the series resistance Rs, thus the fill factor FF can be increased. Moreover, this cell without being shielded on the front not only has a high conversion efficiency, but also looks more beautiful, and at the same time, the components of the full-back electrode are easier to be assembled. The current IBC cell is one of the technical directions to achieve high-efficiency crystalline silicon cells at present.

However, since the method for manufacturing the IBC cell is more complicated, and has tedious steps, a method for manufacturing the solar cell that is simple and that high-efficiency is ensured is needed.

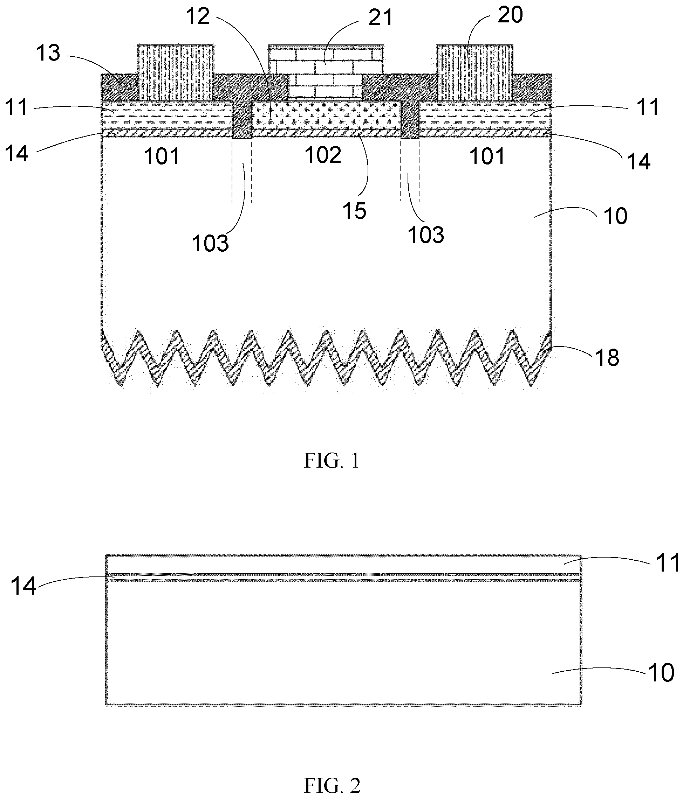

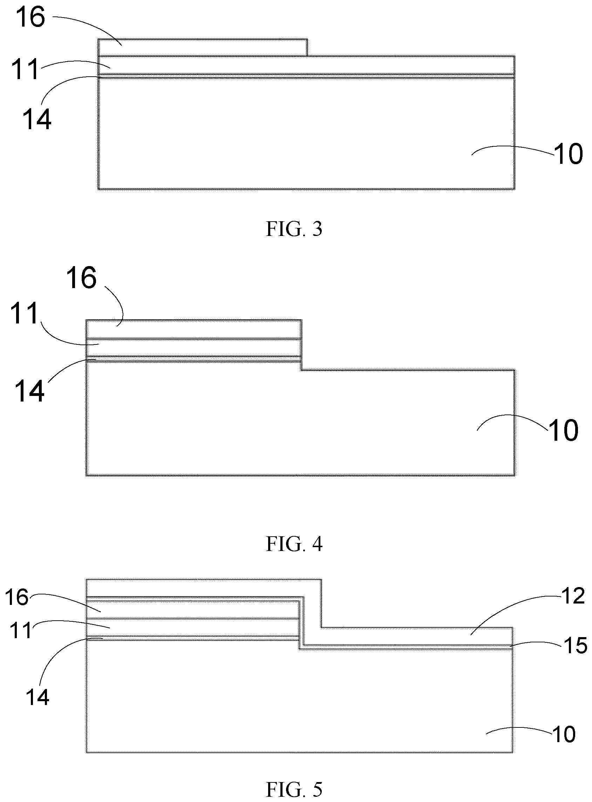

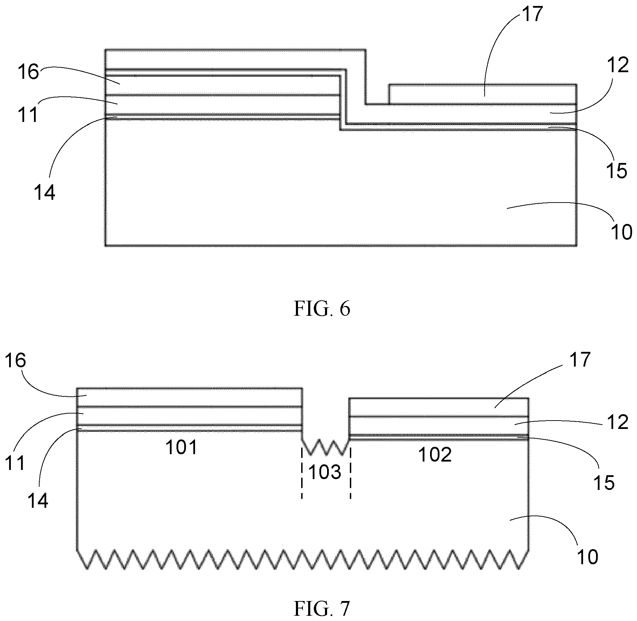

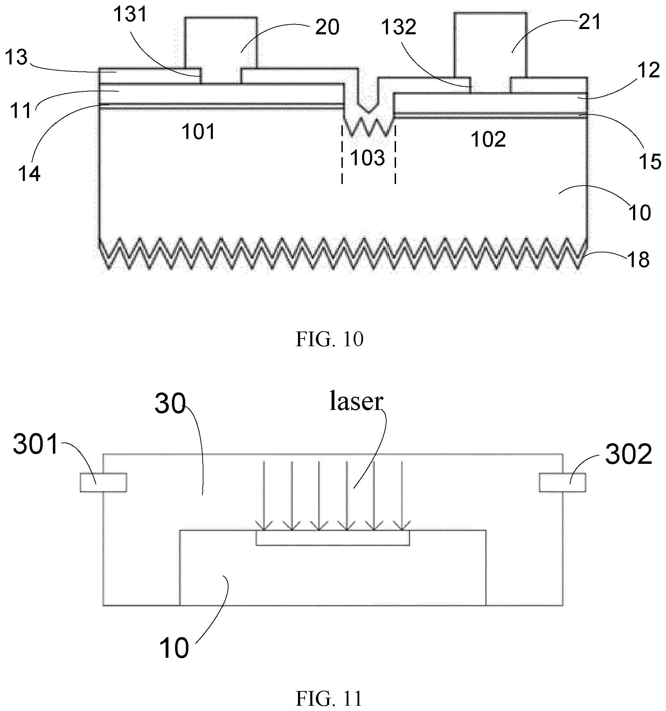

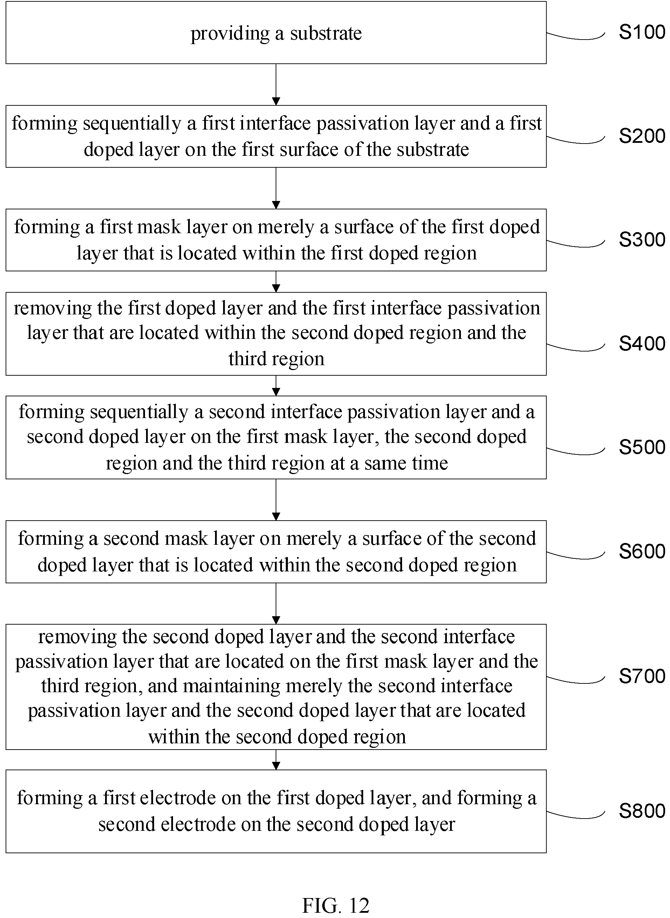

In order to solve the technical problems stated above, referring to FIGs. 1-12, in order to simplify the manufacturing process of back contact solar cells while ensuring a high photoelectric conversion efficiency, a method for manufacturing a back contact solar cell is provided by an embodiment of the present disclosure, wherein the method includes the following steps:
Step S100: providing a substrate 10, wherein the substrate 10 has a first surface and a second surface facing to each other, and on the first surface, there are a first doped region 101 and a second doped region 102 that are arranged in stagger, and a third region 103 for separating the first doped region 101 and the second doped region 102.
Step S200: as shown in FIG. 2, forming sequentially a first interface passivation layer 14 and a first doped layer 11 on the first surface of the substrate 10.
Step S300: as shown in FIG. 3, forming a first mask layer 16 on merely the surface of the first doped layer 11 that is located within the first doped region 101.
Step S400: as shown in FIG. 4, removing the first doped layer 11 and the first interface passivation layer 14 that are located within the second doped region 102 and the third region 103. Specifically, the first doped layer 11 may be removed by the method of dry etching or the method of wet etching. The method of wet etching includes a method of etching by using an alkaline solution or acidic solution. The method of dry etching includes a method of plasma etching. The speed of the removal of the second doped region 102, the third region 103, the first doped layer 11 and the first interface passivation layer 14 is greater than the speed of the removal of the first mask layer 16. Generally, by etching by using a method having different etching speeds, the mask effect of the first mask layer 16 can be excellently realized.
Step S500: as shown in FIG. 5, forming sequentially a second interface passivation layer 15 and a second doped layer 12 on the first mask layer 16, the second doped region 102 and the third region 103 at a same time, wherein a conductive type of the second doped layer 12 is opposite to a conductive type of the first doped layer 11.
Step S600: as shown in FIG. 6, forming a second mask layer 17 on merely the surface of the second doped layer 12 that is located within the second doped region 102.
Step S700: as shown in FIG. 7, removing the second doped layer 12 and the second interface passivation layer 15 that are located on the first mask layer 16 and the third region 103, and maintaining merely the second interface passivation layer 15 and the second doped layer 12 that are located within the second doped region 102.
Step S800: as shown in FIG. 10, forming a first electrode 20 on the first doped layer 11, and forming a second electrode 21 on the second doped layer 12.

In a case of using the technical solution stated above, as compared with the prior art, in the process of patterning the first doped layer 11 and the second doped layer 12, respectively, the mask layers may be formed merely within the required regions of the first doped layer 11 or the second doped layer 12, and the unnecessary mask layers within the other regions are avoided from being formed, the step of removing an unnecessary region mask layer is omitted. Furthermore, the patterning of the second doped layer 12 (i.e., the process of removing the second doped layer 12 within the region outside the second mask layer 17) and the formation of the third region 103 are completed in the same step, the steps are simplified. In addition, in the fabrication of the second doped layer 12 and the patterning of the second doped layer 12, the first mask layer 16 is always maintained on the first doped layer 11. Therefore, in the patterning of the second doped layer 12, the alkali solution is blocked by the first mask layer 16, and therefore the alkali solution cannot destroy the first doped layer 11 of the first doped region 101. Because of the effect of protection on the first doped layer 11 by the first mask layer 16, the patterning fabrication of the first doped region 101 and the second doped region 102 is completed, and the damage on the first doped layer 11 is reduced, the conductive performance of the first doped layer 11 is ensured.

In practical applications, the substrate 10 is a semiconductor substrate 10. The material of the substrate 10 may be materials such as silicon (Si) and germanium (Ge) or materials such as gallium arsenide (GaAs). Obviously, in terms of the conductive type, the substrate 10 may be an intrinsic electrically conductive substrate, an n-type electrically conductive substrate or a p-type electrically conductive substrate. Preferably, the substrate 10 is a p-type electrically conductive substrate or an n-type electrically conductive substrate. As compared with an intrinsic electrically conductive substrate, the p-type electrically conductive substrate or n-type electrically conductive substrate has a better electric conductivity, thus the finally fabricated back contact solar cell has a lower volume resistivity, thereby the efficiency of the back contact solar cell is increased.

Both of the first doped layer 11 and the second doped layer 12 are a semiconductor doped layer. In terms of the internal substance arrangement forms, the first doped layer 11 and the second doped layer 12 may be amorphous, microcrystalline, single crystal, nanocrystalline, polycrystalline and so on. In terms of the specific materials, the materials of the first doped layer 11 and the second doped layer 12 may be silicon (Si), germanium (Ge), silicon carbide (SiCₓ), gallium arsenide (GaAs) and so on. In terms of the conductive types, the first doped layer 11 and the second doped layer 12 may be an n-type doped layer or a p-type doped layer.

In some examples, when the substrate 10 is an n-type substrate, the first doped layer 11 may be a p-type doped layer, and the second doped layer 12 may be an n-type doped layer. Alternatively, when the substrate 10 is a p-type substrate, the first doped layer 11 may be an n-type doped layer, and the second doped layer 12 may be a p-type doped layer.

The first interface passivation layer 14 and the second interface passivation layer 15 are tunneling oxidation layers. A tunneling oxidation layer permits majority carriers to enter a semiconductor doped layer by tunneling while blocking minority carriers from passing through, thus the majority carriers are transported transversely inside the semiconductor doped layer and are collected by an electrode, the recombination of the carriers is reduced, the open-circuit voltage and the short-circuit current of the back contact solar cell are increased. At this moment, the tunneling oxidation layer and the semiconductor doped layer form a tunneling-oxidation-layer passivation-contacting structure, an excellent interface passivation and the selective collection of the carriers can be realized, the photoelectric conversion efficiency of the back contact solar cell is increased. Obviously, the tunneling oxidation layers may also be replaced by other interface passivation layers. The first interface passivation layer 14 and the second interface passivation layer 15 may be one or more of an oxide, a nitride, a carbide and hydrogenated amorphous silicon. The oxide may be one or a mixture of more of silicon oxide, silicon oxynitride, aluminium oxide, titanium oxide, HfO₂, Ga₂O₃, TazOs and Nb₂O₅. The nitride may be one or more of silicon nitride, aluminium nitride, TiN and TiCN. The carbide may be SiC, SiCN and so on.

Both of the thicknesses of the first doped layer 11 and the second doped layer 12 range 50nm-500nm. The process of forming the first interface passivation layer 14 and the first doped layer 11 on the substrate 10 and the process of forming the second doped layer 12 on the first mask layer 16, the second doped region 102 and the third region 103 may be a plasma chemical vapor deposition (PECVD) process, a hot-filament chemical vapor deposition process, a physical vapor deposition (PVD) process, a low-pressure chemical vapor deposition (LPCVD) process, a catalytic chemical vapor deposition process and so on. The process of removing the first interface passivation layer 14 and the first doped layer 11 that are located within the second doped region 102 and the third region 103 and the process of removing the second doped layer 12 located on the third region 103 and the first mask layer 16 may be a laser etching process, an ion milling etching process, a plasma etching process, a reactive-ion etching process, an alkaline etching process, an acidic etching process and so on.

In practical applications, the method for forming electrodes may be more than one. A burnthrough-type slurry may be directly used to be spread-coated onto a passivation film, and then the electrode slurries are caused to pass through the passivation film to form the contacting through the heat treatment. The passivation-film openings may also be firstly formed within a small part of the to-be-contacted region, and then the electrodes may be formed by using the methods such as electrode slurry, laser transfer printing, electroplating, chemical plating, photo-induced electroplating, and the methods of physical vapor deposition such as evaporation and sputtering.

Obviously, the electrodes may also be formed by using one or the combination of multiple methods in the methods stated above. For example, the electrodes may be formed by the method of using a PVD seed layer in cooperation with electrode printing, or the method of the screen printing of the electrode slurries in cooperation with electroplating, or the method of the combination of laser transfer printing and screen-printing sintering, and so on.

For example, in the method of electrode formation by film opening, the passivation film is opened to form the contacting region, wherein a P-type contacting region is formed on the patterned first doped layer 11, and an N-type contacting region is formed on the patterned second doped layer 12.

The electrically conducting slurry is printed onto the contacting regions or the passivation film at the back face and sintered to form the metallized contact, wherein a P-type metal region is formed on the P-type contacting region, and an N-type metal region is formed on the N-type contacting region. Alternatively, the burnthrough-type slurry is printed directly on the patterned passivation film on the first doped region and the second doped region, to form the corresponding P-type metal region and N-type metal region.

Further, after the formation of the electrodes, the method may further include other steps, for example, photoinjection or electric injection of carriers or other heat treatment processes, and efficiency grading or slicing and so on.

The IBC cell having the passivation-contacting structure fabricated by using the method has a good effect of passivation, a low recombination within the metal regions, and a simple process flow. The mask layers formed by no-external-heating oxidation or PECVD combines the process of mask-layer formation and the process of patterning. The back-face PN passivation-contacting interdigitated structure having the isolating region is formed by using the two-step laser oxidation process, the recombination of the region of the direct PN connecting is highly reduced, thus the efficiency of the cell is increased.

Further, in the present embodiment, the first mask layer 16 is a first oxide mask layer; and/or the second mask layer 17 is a second oxide mask layer. Because both of the first mask layer 16 and the second mask layer 17 are an oxide mask layer, the oxide mask layers may be formed directly by oxidation on the first doped layer 11 and the second doped layer 12. Furthermore, the oxide mask layers, as compared with mask layers fabricated in other modes, for example, printed masks, have a higher cleanliness, do not introduce other elements, and may not bring other contamination or impact to the first doped layer and the second doped layer. The oxide masks are easy to wash.

The oxide masks are specifically as: in a case of the first doped layer 11 and the second doped layer 12 are SiC or Si, the formed oxide masks are SiOₓ layers, and in a case of the first doped layer 11 and the second doped layer 12 are germanium, the formed oxide mask layers are GeOₓ.

As shown in FIG. 11, in the present embodiment, the first oxide mask layer is formed by, in an oxygen-containing atmosphere environment, performing laser-irradiation oxidation to merely the surface of the first doped layer 11 that is located within the first doped region 101. And/or, the second oxide mask layer is formed by, in the oxygen-containing atmosphere environment, performing laser-irradiation oxidation to merely the surface of the second doped layer 12 that is located within the second doped region 102.

In specific implementations, by using the device shown in FIG. 11, inside a sealed container 30, the oxygen-containing atmosphere gas is continuously introduced into the container 30 via a gas inlet 301, and the oxygen-containing atmosphere gas is discharged from the container via a gas outlet 302. A specific region of the silicon-containing semiconductor substrate placed into the container 30 undergoes laser irradiation by laser, thereby the oxide mask layers within the region that are swept by the laser are formed.

Because the oxide mask layers are formed directly by laser irradiation on the first doped layer 11 and the second doped layer 12, so that the formation precision of the oxide mask layers is high. As compared with mask layers formed by the method of external heating oxidation or PECVD, the laser irradiation process has a lower heat, the damage on the first doped layer 11 and the second doped layer 12 are reduced.

In the present embodiment, the oxygen-containing atmosphere gas in the oxygen-containing atmosphere environment is one or more of oxygen, ozone, air, CO₂ and N₂O, and may further include other atmosphere gas or carrier gas, for example, nitrogen. In such an oxygen-containing atmosphere environment, by laser irradiation, the first doped layer 11 and the second doped layer 12 can have an oxidation reaction with the gas, to form the oxide mask layers on the surface.

Further, the range of the wavelength of the laser is 190nm-545nm.

As shown in FIG. 7, further, in the present embodiment, in the step S700, the second doped layer 12 and the second interface passivation layer 15 that are located on the first mask layer 16 and the third region 103 are removed specifically by using an alkali solution, and, in the step, a suede structure is formed continuously at the third region 103 of the first surface and the second surface of the substrate 10 by using the same alkali solution.

The multiple process steps of the patterning of the second doped layer 12, the patterning of the third region 103 and the texturing of the second surface of the substrate 10 can be completed at a same time in the same step by using the same alkali solution, the process steps are highly reduced. The suede structure of the third region 103 increases the level of the light trapping of the back face of the back contact solar cell, to increase the power generation capacity when the back contact solar cell is applied to a double-sided assembly. Compared with conventional techniques, the texturing of the second surface is usually performed before the formation of the doped semiconductor layer, which very easily results in damaging on the texture of the second surface in the process of patterning or the process of washing of the doped semiconductor layer. In the present disclosure, the process step of the texturing of the second surface is after the formation of the first doped layer 11 and the second doped layer 12, the integrality of the suede structure of the second surface and its light-trapping performance are ensured. Especially, when the texturing structure of the second surface is a nano-sized suede structure, the various types of processes of the washing and the patterning nearly definitely destroy the nano-sized suede texturing structure. In recent years, the nano-sized microstructure as the texturing structure of the light receiving face is increasingly more extensively used, and therefore the method of post-texturing has an increasingly prominent advantage. The nano-sized suede texturing structure has a better effect of light trapping, and, because the light receiving face of the back contact solar cell does not have an electrode, after the nano-sized suede texturing structure is applied to the back contact solar cell, the color of the second surface is more beautiful. Therefore, the nano-sized suede texturing structure is more suitable for the back contact solar cell.

Specifically, in the present embodiment, the second doped layer 12 and the second interface passivation layer 15 that are located on the first mask layer 16 and the third region 103 are removed by using an alkali solution of KOH, NaOH or tetramethyl ammonium hydroxide with the mass percentage of 1wt%-5wt% at 70°C-90°C, and a suede structure is formed continuously at the third region 103 of the first surface and the second surface at a same time by using the same alkali solution. Under such conditions, a better effect of etching can be realized, and a uniform nano-sized micro-suede structure can be formed.

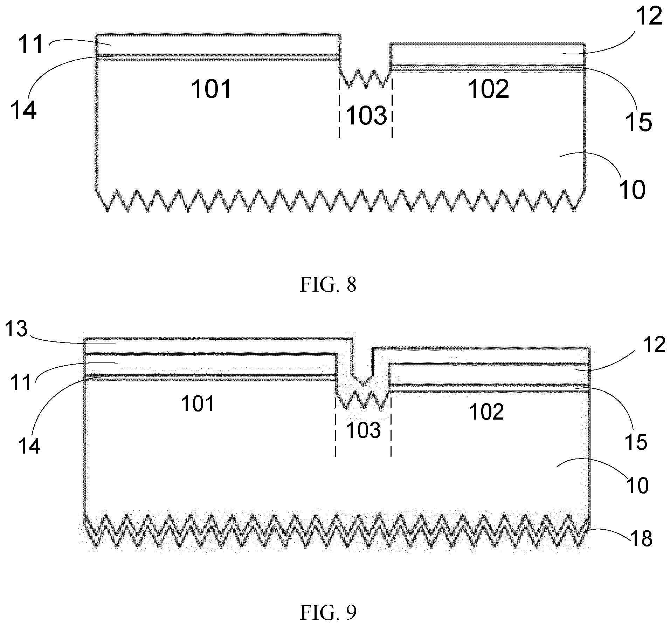

As shown in FIG. 8-FIG. 10, in the present embodiment, in the step S800, the step of forming the first electrode 20 on the first doped layer 11, and forming the second electrode 21 on the second doped layer 12 specifically includes:

Step S801: removing the first mask layer 16 located on the first doped layer 11 and the second mask layer 17 located on the second doped layer 12. After the step S700 is completed, because the first mask layer 16 is still maintained on the first doped layer 11, and the second mask layer 17 is further still maintained on the second doped layer 12, therefore after the first mask layer 16 and the second mask layer 17 have completed the effect of protection on the first doped layer 11 and the second doped layer 12, the first mask layer 16 and the second mask layer 17 may be removed firstly, and subsequently the electrodes are fabricated.

Step S802: forming the first surface passivation layer 13 at the first doped layer 11, the second doped layer 12 and the third region 103 at a same time.

Step S803: forming the first electrode 20 on the first surface passivation layer 13 located at the first doped layer 11, and forming the second electrode 21 on the first surface passivation layer 13 located at the second doped layer 12, wherein the first electrode 20 is electrically contacted with the first doped layer 11, and the second electrode 21 is electrically contacted with the second doped layer 12.

After the patterning of the first doped layer 11 and the second doped layer 12 and the formation of the third region 103 are completed, the first mask layer 16 and the second mask layer 17 may be removed, to improve the performance of electrically conducting contacting between the first doped layer 11 and the first electrode 20 and between the second doped layer 12 and the second electrode 21. Furthermore, the first surface passivation layer 13 can perform surface passivation to the back contact solar cell, to passivate the dangling bonds at the first doped layer 11, the second doped layer 12 and the third region 103, to reduce the recombination rate of the carriers at the first surface, and to increase the photoelectric conversion efficiency. The first electrode 20 and the second electrode 21 are electrically contacted with the first doped layer 11 and the second doped layer 12 via a first opening 130 and a second opening 131 respectively, to form local ohmic contacting between the metals and the semiconductors, the contact areas between the metal electrodes and the first doped layer 11 and the second doped layer 12 are reduced, the contact resistances are reduced, the recombination rates of the carriers at the surfaces of the electrodes are further reduced, and the open-circuit voltage is increased.

Specifically, in practical applications, the process of forming the first surface passivation layer 13 may be a plasma chemical vapor deposition (PECVD) process, a hot-filament chemical vapor deposition process, a physical vapor deposition (PVD) process, a low-pressure chemical vapor deposition (LPCVD) process, a catalytic chemical vapor deposition process and so on. When the back contact solar cell has the first surface passivation layer 13, and the first electrode 20 and the second electrode 21 are continuously contacting electrodes, the method of forming the first electrode 20 and the second electrode 21 may also be that the electrode slurries are spread-coated onto the first surface passivation layer 13, and then by being sintered, the electrode slurries are caused to pass through the first surface passivation layer 13 to be electrically contacted with the second doped layer 12, respectively. When the back contact solar cell has the first surface passivation layer 13, and the first electrode 20 and the second electrode 21 are locally contacting electrodes, the method of forming the first electrode 20 and the second electrode 21 may further be: firstly tapping the first opening 130 and the second opening 131 in the first surface passivation layer 13, and then forming the first electrode 20 and the second electrode 21 that locally contact by using the methods such as slurry printing, laser transfer printing, electroplating, chemical plating, photo-induced electroplating, and methods of physical vapor deposition such as vacuum vapor deposition and magnetron sputtering. The tapping method may include laser film opening, or film opening by using an etching slurry that can react with the first surface passivation layer 13. The electric contacting via the openings can enable the back contact solar cell to obtain a low recombination within the metal regions, thereby a high conversion efficiency of the back contact solar cell is ensured. Obviously, the first electrode 20 and the second electrode 21 may also be formed by using one the combination of multiple methods in the methods stated above. For example, the first electrode 20 and the second electrode 21 may be formed by the method of using a seed layer of physical vapor deposition (PVD) in cooperation with electrode printing, or the method of the screen printing of the electrode slurries in cooperation with electroplating, or the method of the combination of laser transfer printing and screen-printing sintering, and so on.

As an example, as shown in FIG. 8-FIG.10, the step of forming the first electrode 20 on the first doped layer 11, and forming the second electrode 21 on the second doped layer 12 specifically is that : on the first doped layer 11, the second doped layer 12 and the third region 103, by using a process of PECVD, a layer of silicon-nitride is deposited as the first surface passivation layer 13; and on the first surface passivation layer 13 located on the first doped layer 11, by using laser film opening, the first opening 130 is tapped; and then the first electrode 20 is formed by using a method of printing an electrically conducting slurry, on the first surface passivation layer 13 located on the second doped layer 12, by using the laser film opening, the second opening 131 is tapped, and, subsequently, the second electrode 21 is formed by using a method of printing an electrically conducting slurry, wherein the first electrode 20 is electrically contacted with the second doped layer 121 via the first opening 130, and the second electrode 21 is electrically contacted with a third doped layer 122 via the second opening 131.

As an example, after the formation of the first electrode 20 and the second electrode 21, the method may include other steps, for example, photoinjection or electric injection of the carriers or other heat treatment processes, and efficiency grading or slicing and so on.

In some examples, the step of forming the third region 103 may be disposed before the formation of the first surface passivation layer 13. The step of forming the third region 103 may also be disposed after the fabrication of the back contact solar cell are completed, but that might compromise a part of the passivation of the third region 103.

Further, in the present embodiment, in the step S801, the first mask layer 16 and the second mask layer 17 may be removed by using an etching solution containing the fluorine element. When the first mask layer 16 and the second mask layer 17 are silicon-oxide layers, the silicon-oxide layers may be removed specifically by using a solution containing HF, NH₄F and so on. The etching solution containing the fluorine element can easily remove the mask layers, especially the oxide mask layers.

In the present embodiment, in the step S802, the step of forming the first surface passivation layer 13 at a same time at the first doped layer 11, the second doped layer 12 and the third region 103 further includes forming a second surface passivation layer 18 on the second surface. In such a configuration, the formation of the second surface passivation layer 18 and the formation of the first surface passivation layer 13 are in the same step, the steps are simplified, and the second surface passivation layer 18 has the effect of reducing the incident-light reflection and passivating.

Specifically, the process of forming the second surface passivation layer 18 may be the plasma chemical vapor deposition (PECVD) process, the hot-filament chemical vapor deposition process, the physical vapor deposition (PVD) process, the low-pressure chemical vapor deposition (LPCVD) process, the catalytic chemical vapor deposition process and so on.

In some examples, after the second surface passivation layer 18 are formed, an antireflection layer may be formed on the second surface passivation layer 18. The antireflection layer can reduce the reflection to the light rays entering the second surface, and increase the refraction to the light rays, to increase the utilization ratio of the light rays entering the second surface, thereby the photoelectric conversion efficiency of the back contact solar cell is increased. The surface passivation layer and the antireflection layer may be formed by using one or more of silicon nitride, silicon oxide, silicon oxynitride, aluminium oxide, silicon carbide and amorphous silicon.

In the present embodiment, the first doped layer 11 and the second doped layer 12 are formed by an in-situ doping method or a non-in-situ doping method. In other words, the first doped layer 11 and the doped film layer 12 may be directly formed, or an intrinsic semiconductor layer and an intrinsic semiconductor film layer may also be firstly formed, and subsequently they are doped respectively to form the first doped layer 11 and the doped film layer 12.

Further, in the present embodiment, before the step of forming the first electrode 20 on the first doped layer 11, and forming the second electrode 21 on the second doped layer 12, the method further includes: performing a heat-treatment process, wherein the heat-treatment process crystallizes at least a part of the first doped layer 11 and/or the second doped layer 12. Specifically, the p-type or n-type semiconductor layer may undergo heat treatment, to cause the dopant to be further distributed, or to cause the structure of the semiconductor layer to change, which is more beneficial to improve the performance of the cell. For example, when the first doped layer 11 and the second doped layer 12 are amorphous semiconductors or microcrystalline semiconductors, the heating annealing can cause at least a part of the first doped layer 11 and/or the second doped layer 12 to be crystallized, the electrical conductivities of the first doped layer 11 and the second doped layer 12 are increased. In addition, the heating annealing can also cause the first interface passivation layer 14 and the second interface passivation layer 15 (for example, a tunneling oxidation layer) to be more beneficial to the selective transportation of the carriers. The heating can also cause the doped element to enter the tunneling oxidation layers and the substrate 10, thereby the transmission resistance is reduced.

Taking the fabrication of the n-type back contact solar cell shown in FIG. 1 as an example, a specific process of manufacturing the n-type back contact solar cell is provided by the present embodiment:

The first step: providing an n-type silicon substrate 10, and then performing sequentially damage removing treatments such as polishing and washing and so on to the n-type silicon substrate 10.

The second step: as shown in FIG. 2, on a first surface of the n-type silicon substrate 10, by using a PECVD device, depositing a layer of the silicon-oxide tunneling oxidation layer and a boron-doped p-type polycrystalline silicon layer, wherein the silicon-oxide tunneling oxidation layer serves as the first interface passivation layer 14, and the boron-doped p-type polycrystalline silicon layer serves as the first doped layer 11.

The third step: as shown in FIG. 3, in an oxygen-containing atmosphere environment, performing laser irradiation to merely the surface of the p-type polycrystalline silicon layer that is located within the first doped region 101 to form the first oxide mask layer.

The fourth step: as shown in FIG. 4, by using an alkaline etching process, removing the p-type polycrystalline silicon layer and the silicon-oxide tunneling oxidation layer that are located within the second doped region 102 and the third region 103, to form the first doped layer 11 and the first interface passivation layer 14 merely within the first doped region 101, wherein the thickness of the first doped layer 11 is 200nm.

The fifth step: as shown in FIG. 5, on the first oxide mask layer and the exposed second doped region 102 and third region 103, by using a PECVD device, depositing a layer of silicon-oxide tunneling oxidation layer and a phosphorus-doped n-type polycrystalline-silicon layer, wherein the silicon-oxide tunneling oxidation layer serves as the second interface passivation layer 15, and the phosphorus-doped n-type polycrystalline-silicon layer serves as the second doped layer 12.

The sixth step: as shown in FIG. 6, in an oxygen-containing atmosphere environment, performing laser irradiation to merely the surface of the n-type polycrystalline-silicon layer that is located within the second doped region 102 to form the second oxide mask layer.

The seventh step: as shown in FIG. 7, by using an alkaline etching process, removing the second doped layer 12 that is located on the third region 103 and the first oxide mask layer, to maintain merely the second interface passivation layer 15 and the second doped layer 12 that are located within the second doped region 102, wherein the thickness of the second doped layer 12 is 200nm; and at a same time, performing texturing treatment to the third region 103 and the second surface by using the same alkali solution, to form a suede structure.

The eighth step: as shown in FIG. 8, by using a fluorine-containing solution, removing the first oxide mask layer and the second oxide mask layer.

The ninth step: as shown in FIG. 9, by using a PECVD device, on the first doped layer 11, the third region 103 and the second doped layer 12, depositing a layer of silicon nitride as the first surface passivation layer 13, and, at a same time, on the suede structure of the second surface, depositing a layer of silicon nitride as the second surface passivation layer 18.

The tenth step: as shown in FIG. 10, on the first surface passivation layer 13 within the first doped region 101, by using laser, tapping the first opening 130, and, subsequently, forming the first electrode 20 by using a method of printing an electrically conducting slurry, wherein the first electrode 20 is electrically contacted with the first doped layer 11 via the first opening 130; and on the first surface passivation layer 13 within the second doped region 102, by using laser, tapping the second opening 131, and, subsequently, forming the second electrode 21 by using a method of printing an electrically conducting slurry, wherein the second electrode 21 is electrically contacted with the second doped layer 12 via the second opening 131, to form the back contact solar cell shown in FIG. 1. Both of the first electrode 20 and the second electrode 21 are a locally contacting electrode, and both of the widths of the first electrode 20 and the second electrode 21 are 50µm.

In the present embodiment, in the direction of the staggered arrangement of the first doped region 101 and the second doped region 102, the width of the first doped region 101 is greater than the width of the second doped region 102. The width of the first doped region 101 is 600µm-2000µm. The width of the second doped region 102 is 200µm-1000µm. Based on that, the width of the first doped layer 11 on the first doped region 101 is greater than the width of the second doped layer 12 on the second doped region 102, and the formed PN junctions have a large width range; in other words, the area of the separation of the carriers is large, which facilitates the separation of the carriers, and thus the photoelectric conversion efficiency of the cell is increased. Preferably, the width range of the first doped region 101 is 600µm-1500µm, and the width range of the second doped region 102 is 200µm-800µm.

As an example, the width of the first doped region 101 may be 600µm, and the width of the second doped region may be 500µm. Alternatively, the width of the first doped region 101 may be 2000µm, and the width of the second doped region may be 200µm. Alternatively, the width of the first doped region 101 may be 1400µmm, and the width of the second doped region may be 1000µm.

In some examples, in the direction of the staggered arrangement of the first doped region and the second doped region, the width range of the third region 103 is 10µm-100µm. A too wide third region 103 might result in waste of the effective area of the back contact solar cell, and the effective carriers are difficult to be collected, thus the performance of the cell is reduced. The third region 103 disposed between the first doped region 101 and the second doped region 102 causes the first doped region 101 and the second doped region 102 to be separated at the boundaries, and the design of insulator between the positive electrode and the negative electrode in the prior art is omitted, the steps of the produce process can be reduced, and the space complexity can also be reduced. In such a structure there is not the phenomenon of coexistence of the positive electrode and the negative electrode in the vertical direction, the phenomenon of electric leakage of the back contact solar cell is prevented from being generated. Furthermore, the reliability performance of the cell in the subsequent product can be improved, and the difficulty in the production process of the back contact solar cell is reduced.

As an example, the width of the third region may be 10µm, may also be 100µm, and may also be 60µm.

As some possible embodiments, as shown in FIG. 1, the surface of the first doped region 101 and/or the surface of the second doped region 102 are a polished surface.

Based on that, both of the surfaces of the first doped region 101 and the second doped region 102 may be a polished surface, so that the light rays that enter the second surface and pass through the back contact solar cell are reflected again, thus the light rays have an opportunity of being re-utilized by the back contact solar cell, thereby the photoelectric conversion efficiency of the back contact solar cell is increased. In addition, the polished surfaces have a better flatness, and subsequently the formation of the other layers on the polished surfaces has a better effect, which facilitates to reduce the generation of interface defects, and accordingly reduce the recombination of the carriers caused by the defects, which facilitates to improve the passivation performance of the back contact solar cell, thereby the photoelectric conversion efficiency of the back contact solar cell is increased.

The IBC cell having the passivation-contacting structure fabricated by using the method has a good effect of passivation, a low recombination within the metal regions, and a simple process flow. The mask layers formed by using the method of no-external-heating oxidation or PECVD combine the process of mask-layer formation and the process of patterning. By using the laser oxidation process, the back-face PN passivation-contacting interdigitated structure having the third region is formed, which highly reduces the recombination within the region of the direct PN connecting, thereby the efficiency of the cell is increased. In the description on the above embodiments, the particular features, structures, materials or characteristics may be combined in any one or more embodiments or examples in a suitable form.

The above are merely particular embodiments of the present disclosure, and the protection scope of the present disclosure is not limited thereto. All of the variations or substitutions that a person skilled in the art can easily envisage within the technical scope disclosed by the present disclosure should fall within the protection scope of the present disclosure. Therefore, the protection scope of the present disclosure should be subject to the protection scope of the claims.

## Claims

1. A method for manufacturing a back contact solar cell, **characterized in that** the method comprises:
providing a substrate, wherein the substrate has a first surface and a second surface facing to each other, and on the first surface, there are a first doped region and a second doped region that are arranged in stagger, and a third region for separating the first doped region and the second doped region;
forming sequentially a first interface passivation layer and a first doped layer on the first surface of the substrate;
forming a first mask layer on merely a surface of the first doped layer that is located within the first doped region;
removing the first doped layer and the first interface passivation layer that are located within the second doped region and the third region;
forming sequentially a second interface passivation layer and a second doped layer on the first mask layer, the second doped region and the third region at a same time, wherein a conductive type of the second doped layer is opposite to a conductive type of the first doped layer;
forming a second mask layer on merely a surface of the second doped layer that is located within the second doped region;
removing the second doped layer and the second interface passivation layer that are located on the first mask layer and the third region, and maintaining merely the second interface passivation layer and the second doped layer that are located within the second doped region; and
forming a first electrode on the first doped layer, and forming a second electrode on the second doped layer.

2. The method for manufacturing the back contact solar cell according to claim 1, **characterized in that** the first mask layer is a first oxide mask layer; and/or the second mask layer is a second oxide mask layer.

3. The method for manufacturing the back contact solar cell according to claim 2, **characterized in that** the first oxide mask layer is formed by, in an oxygen-containing atmosphere environment, performing laser-irradiation oxidation to merely the surface of the first doped layer that is located within the first doped region; and/or
the second oxide mask layer is formed by, in the oxygen-containing atmosphere environment, performing laser-irradiation oxidation to merely the surface of the second doped layer that is located within the second doped region.

4. The method for manufacturing the back contact solar cell according to claim 3, **characterized in that** a gas in the oxygen-containing atmosphere environment is one or more of oxygen, ozone, air, CO₂ and N₂O.

5. The method for manufacturing the back contact solar cell according to claim 1, **characterized in that** the second doped layer and the second interface passivation layer that are located on the first mask layer and the third region are removed by using an alkali solution, and a suede structure is formed continuously at the third region of the first surface and the second surface at a same time by using the same alkali solution.

6. The method for manufacturing the back contact solar cell according to claim 5, **characterized in that** the second doped layer and the second interface passivation layer that are located on the first mask layer and the third region are removed by using an alkali solution of KOH, NaOH or tetramethyl ammonium hydroxide with a mass percentage of 1wt%-5wt% at 70°C-90°C, and the suede structure is formed continuously at the third region of the first surface and the second surface at a same time by using the same alkali solution.

7. The method for manufacturing the back contact solar cell according to claim 1, **characterized in that** the step of forming the first electrode on the first doped layer, and forming the second electrode on the second doped layer comprises:
removing the first mask layer located on the first doped layer and the second mask layer located on the second doped layer;
forming a first surface passivation layer at the first doped layer, the second doped layer and the third region at a same time; and
forming the first electrode on the first surface passivation layer located at the first doped layer, and forming the second electrode on the first surface passivation layer located at the second doped layer, wherein the first electrode is electrically contacted with the first doped layer, and the second electrode is electrically contacted with the second doped layer.

8. The method for manufacturing the back contact solar cell according to claim 6, **characterized in that** the first mask layer and the second mask layer are removed by using an etching solution containing a fluorine element; and/or
the step of forming the first surface passivation layer on the first doped layer, the second doped layer and the third region at a same time further comprises forming a second surface passivation layer on the second surface.

9. The method for manufacturing the back contact solar cell according to claim 1, **characterized in that** the first doped layer and the second doped layer are formed by an in-situ doping method or a non-in-situ doping method.

10. The method for manufacturing the back contact solar cell according to claim 1, **characterized in that** before the step of forming the first electrode on the first doped layer, and forming the second electrode on the second doped layer, the method further comprises: performing a heat-treatment process, wherein the heat-treatment process crystallizes at least a part of the first doped layer and/or the second doped layer.
